# DEMANDE DE BREVET EUROPEEN

(11) **EP 4 708 359 A1**
(43) Date de publication de la demande: **11.03.2026**
(21) Numéro de dépôt: 25200629.1
(22) Date de dépôt: 05.09.2025
(51) Int. Cl.: H01L 23/40

(54) **DISPOSITIF ÉLECTRIQUE ET DISPOSITIF DE MAINTIEN D'UNE PLAQUE DE REFROIDISSEMENT DU DISPOSITIF ÉLECTRIQUE**

(30) Priorité: 06.09.2024 FR 2409458
(71) Demandeur: Valeo eAutomotive Germany GmbH, 91056 Erlangen (DE)
(72) Inventeur: MASSOL, Laurent, 94046 CRETEIL CEDEX (FR); ROLINET-GUO, Jingjin, 95892 CERGY PONTOISE (FR); GUERIN, Fabien, 94046 CRETEIL CEDEX (FR); KOPP, Gabriel, 94046 CRETEIL CEDEX (FR)
(74) Mandataire: Valeo Powertrain Systems

(57) **Abrégé**

Dispositif électrique comprenant une plaque de refroidissement, des composants électroniques disposés sur ladite plaque de refroidissement, la plaque de refroidissement présentant une face supérieure en regard du module de puissance et une face inférieure opposée, un moyen d'attache thermique étant disposé entre l'au moins un module de puissance et la face supérieure de la plaque de refroidissement, un dispositif de maintien étant rendu solidaire de la face inférieure de la plaque de refroidissement, caractérisé en ce que le dispositif de maintien est formé d'une tôle comprenant des zones de déformation locale aptes à renforcer structurellement le dispositif de maintien.

## Description

La présente invention se rapporte au domaine des dispositifs électroniques tels que les dispositifs électriques pour voiture électrique ou hybride.

Les dispositifs électroniques comprennent divers composants électroniques tel que des modules de puissance, des bobines ou des capacités, sans que cette liste soit exhaustive. Ces composants électroniques produisent de la chaleur lors de l'utilisation du dispositif électrique.

Les dispositifs électroniques sont utilisés dans des systèmes qui nécessitent des puissances toujours plus élevées. L'augmentation de ces puissances s'accompagne d'une production de chaleur de plus en plus importante lors du fonctionnement des dispositifs électroniques et impose de trouver des solutions pour réduire ces contraintes thermiques qui peuvent générer des dysfonctionnements des composants du dispositif électrique.

Plus particulièrement, il est connu d'équiper les dispositifs électriques d'une plaque de refroidissement au sein de laquelle est apte à circuler un fluide caloporteur et qui comprend une paroi contre laquelle sont disposés les composants électroniques à refroidir et notamment les modules de puissance qui sont les composants qui dégagent le plus de calories. Les composants électroniques sont rendus solidaires de la plaque de refroidissement par une opération de brasage au cours de laquelle les composants et la plaque sont placés dans un four de façon à polymériser de la matière entre les composants électroniques et la plaque de refroidissement. En d'autres termes, les composants électroniques, et notamment les modules de puissance, sont figés via un moyen d'attache thermique configuré pour se liquéfier lorsque celui-ci atteint une certaine température puis se figer géométriquement l'interface à haute température Le module de puissance est un composant de plus en plus utilisé dans les systèmes électroniques dans la mesure où il permet d'assembler une pluralité de puces électroniques dans un espace réduit. Plus précisément, le module de puissance comprend un boîtier au sein duquel sont disposées côte à côte des puces électroniques. Le boîtier comporte un socle permettant de supporter des puces électroniques et une paroi de recouvrement qui recouvre les puces et qui forme, en combinaison avec le socle, un volume interne dans lequel s'étendent les puces. Les puces sont connectées à des broches de connexion électriques qui s'étendent à l'extérieur du module de puissance, notamment pour permettre le raccordement électrique des puces électroniques, logées à l'intérieur du boîtier, à un réseau électrique via une carte de circuits imprimés.

Le module de puissance présente une forme rectangulaire, définie par la forme rectangulaire du boîtier. Plusieurs modules de puissance sont disposés sur la plaque de refroidissement. La plaque de refroidissement présente une dimension plus importante que la dimension correspondante formée par la juxtaposition des composants électroniques disposés sur la plaque de refroidissement. Le boîtier des modules de puissance est dans un matériau isolant présentant des caractéristiques thermiques différentes de celles de la plaque de refroidissement.

Il est connu que les plaques de refroidissement et/ou les boîtiers de composants électroniques se dilatent et fléchissent celles-ci passent dans un four puis refroidissent. Il résulte de ce qui précède que lorsque l'assemblage est placé dans le four et chauffé, la plaque de refroidissement est amenée à se dilater différemment des boitiers des composants électroniques, aussi bien du fait de la différence de matériau que du fait de la différence de dimensionnements. L'assemblage rigide de ces composants crée un fléchissement résultant des différents types de comportement en dilatation.

Une telle différence de déformation alors que les modules sont figés sur la plaque de refroidissement peut alors endommager les modules de puissance jusqu'à désolidariser les composants électroniques de la plaque de refroidissement ou encore créer une déformation géométrique trop importante rendant le dispositif non conforme.

La présente invention s'inscrit dans ce contexte et vise à proposer un dispositif électrique au sein duquel la plaque de refroidissement est rigidifiée de manière légère et peu coûteuse.

La présente invention propose un dispositif électrique comprenant une plaque de refroidissement, des composants électroniques disposés sur ladite plaque de refroidissement, la plaque de refroidissement présentant une face supérieure en regard d'au moins un composant électronique et une face inférieure opposée, un moyen d'attache thermique étant disposé entre l'au moins un composant électronique et la face supérieure de la plaque de refroidissement, un dispositif de maintien étant rendu solidaire de la face inférieure de la plaque de refroidissement, caractérisé en ce que le dispositif de maintien est formé d'une tôle comprenant des zones de déformation locale aptes à renforcer structurellement le dispositif de maintien.

Le dispositif électrique selon l'invention peut par exemple être un convertisseur électrique, notamment un onduleur ou un convertisseur continu-continu, apte à équiper un véhicule automobile électrique ou hybride, qui a notamment pour fonction de permettre la transformation d'un courant alternatif fourni par une borne de recharge domestique en un courant continu exploitable par les composants électriques du véhicule électrique, et notamment les composants d'un système d'entraînement du véhicule électrique ou la transformation d'un courant continu fourni par une batterie en courant alternatif pour piloter une machine électrique.

Selon une caractéristique, les composants électroniques peuvent consister en un module de puissance.

Ce dispositif électrique est ici caractérisé par la présence du dispositif de maintien associé à la plaque de refroidissement du dispositif électrique, le dispositif de maintien ayant pour fonction de réduire la déformation de la plaque de refroidissement lors du passage dans des équipements d'assemblage, par exemple un four et/ou dans une presse d'assemblage.

Le dispositif de maintien se déforme moins que la plaque de refroidissement sous l'effet de la chaleur. Ce dispositif de maintien située sous la plaque de refroidissement, à l'opposé des composants électroniques limite la flèche de la plaque de refroidissement et permet de ne pas endommager les modules de puissance lors du refroidissement.

### Selon une caractéristique,

Le dispositif de maintien est ici particulièrement avantageux, et notamment simple à réaliser et peu coûteux, en ce qu'il est formé d'une tôle comprenant des zones de déformation locale. La tôle du dispositif de maintien est une tôle dont l'épaisseur est comprise entre 0.5mm et 4mm, de préférence et 2.5mm et 3.5mm, par exemple 3 mm. Une telle épaisseur permet de limiter la quantité de matière première nécessaire pour la réalisation du dispositif de maintien et donc de limiter le poids du dispositif électrique. La rigidité nécessaire du dispositif de maintien pour conférer le maintien adéquat à la plaque de refroidissement est alors augmentée en réalisant des zones de déformation locale de la tôle.

Les zones de déformation locale permettent de renforcer structurellement le dispositif de maintien, de façon à limiter la déformation du dispositif de maintien lors du passage dans un four et de la montée en température associée. Ainsi, lorsque le dispositif électrique est disposé dans un four pour solidariser les composants électroniques à la plaque de refroidissement, via le moyen d'attache thermique interposé, le dispositif de maintien rigidifie la plaque de refroidissement et réduit la déformation subie par cette plaque de refroidissement lors de la descente en température. De la sorte, on évite des contraintes fortes sur le composant électronique qui lui reste de forme sensiblement constante. Le dispositif de maintien permet ainsi d'assurer le bon fonctionnement du dispositif électrique en formant un moyen anti-flexion de la plaque de refroidissement.

Selon une caractéristique optionnelle de l'invention, la tôle du dispositif de maintien comprend une pluralité de pliures donnant au dispositif de maintien la forme d'un corps creux.

Les pliures sont représentatives de zones de déformation locales permettant de renforcer structurellement le dispositif de maintien. La tôle du dispositif de maintien comprend une pluralité de pliures formant le dispositif de maintien, ce qui rigidifie le dispositif de maintien par la multiplication des zones de déformation locale, et ces pliures sont agencées de telle sorte que le dispositif de maintien présente une section, dans un plan de coupe perpendiculaire à une direction d'allongement principal le long de laquelle sont formées les pliures, en corps creux, c'est-à-dire une section sensiblement fermée pour améliorer encore la rigidité de la pièce. Les pliures permettent d'augmenter le moment quadratique du dispositif de maintien dans les deux principaux axes de flexions de la plaque de refroidissement.

Selon une caractéristique optionnelle de l'invention, la tôle du dispositif de maintien est pliée de sorte que le dispositif de maintien présente deux parois principales sensiblement parallèles à la face inférieure de la plaque de refroidissement et à distance l'une de l'autre pour définir un volume interne.

La tôle est pliée de sorte que deux parois du dispositif de maintien soient parallèles entre elles et parallèle à la face inférieure de la plaque de refroidissement. Une première paroi est en regard de ladite plaque de refroidissement. La première paroi comprend une surface apte à recevoir la plaque de refroidissement, le cas échéant avec un moyen d'attache thermique interposé. La distance entre les deux parois définit un volume interne. De cette façon le dispositif de maintien est constitué d'un corps creux renforçant sa structure et le dispositif de maintien dispose donc de caractéristiques techniques semblables à celles d'une paroi épaisse sans les contraintes de poids et de coût de matériaux.

Selon une caractéristique optionnelle de l'invention, la tôle du dispositif de maintien est pliée de sorte qu'un bord d'extrémité libre du dispositif de maintien est au voisinage d'un autre bord d'extrémité libre pour fermer le volume interne.

En d'autres termes, les différentes pliures faites sur la tôle sont réalisées pour que des bords d'extrémités libres, qui sont opposés lorsque la tôle est plane à l'origine, se rejoignent de façon à fermer le dispositif de maintien en section.

Selon une caractéristique optionnelle de l'invention, un bord d'extrémité libre comprend une pliure formant un décrochage dimensionné pour recevoir l'autre bord d'extrémité libre.

Le décrochage formé par pliure d'un premier bord d'extrémité libre est tel que le deuxième bord d'extrémité libre de la tôle peut venir reposer contre le premier bord d'extrémité libre et former malgré tout une paroi plane en regard de la plaque de refroidissement. On s'assure ainsi du bon positionnement du dispositif de maintien contre la plaque de refroidissement et de la rigidité optimale du dispositif de maintien puisque les deux bords d'extrémité libre reposent l'un contre l'autre au lieu d'être seulement en regard l'un de l'autre.

Selon une caractéristique optionnelle de l'invention, au moins une zone de déformation locale est formée par un bossage résultant d'une opération d'estampage.

Le bossage est réalisé par la forme correspondante d'une matrice d'estampage. Une même matrice peut réaliser une pluralité de bossages sur une même tôle, et le cas échéant sur une succession de tôles découpées au fur et à mesure pour une production à grande échelle. Le bossage peut être réalisé sur une des parois principales, notamment sur la première paroi.

Selon une caractéristique optionnelle de l'invention, le dispositif de maintien présente une paroi de support sensiblement parallèle à la face inférieure de la plaque de refroidissement et destinée à permettre la fixation du dispositif de maintien sur la plaque de refroidissement, le dispositif de maintien présentant en outre au moins une paroi latérale prolongeant sensiblement perpendiculairement la paroi de support et venant au contact d'au moins un bord de la plaque de refroidissement.

Le bord de la plaque de refroidissement est une face perpendiculaire aux faces inférieure et supérieure de la plaque de refroidissement et la paroi latérale est parallèle au bord de la plaque de refroidissement.

Selon une caractéristique optionnelle de l'invention, le dispositif de maintien comprend deux parois latérales en regard de deux bords opposés de la plaque de refroidissement.

Les pliures de la tôle du dispositif de maintien sont réalisées de telle sorte que les parois latérales sont disposées à une distance l'une de l'autre qui est sensiblement supérieure à la dimension correspondante entre deux bords opposés de la plaque de refroidissement.

Les parois latérales permettent de centrer et de bloquer la plaque de refroidissement sur le dispositif de maintien.

Selon une caractéristique optionnelle de l'invention, la paroi latérale est formée par des pliures dans la tôle du dispositif de maintien. La paroi latérale est réalisée par une pluralité de pliures formant un corps creux additionnel prolongeant perpendiculairement le corps creux principal du dispositif de maintien. La paroi latérale est réalisée par une première pliure à une extrémité de la première paroi du dispositif de maintien, par une deuxième pliure repliant la paroi latérale sur elle-même, et par une troisième pliure permettant de former la paroi parallèle à la première paroi.

Selon cette caractéristique, la paroi latérale présente une longueur, selon une direction longitudinale parallèle au plan de la face inférieure de la plaque de refroidissement, qui est égale à la longueur dans cette même direction de la première paroi du dispositif de maintien.

Selon une caractéristique optionnelle de l'invention, la paroi latérale est réalisée par des extensions locales résultant respectivement d'une découpe dans la première paroi et d'une pliure de ladite découpe pour donner à cette découpe une position sensiblement perpendiculaire à la première paroi. L'extension est alors une partie de la première paroi pliée de sorte que celle-ci soit en saillie de la première paroi et l'on comprend que la paroi latérale est formée de portions de longueur inférieure à la longueur de la première paroi.

Selon une caractéristique optionnelle de l'invention, le dispositif de maintien comporte un renfort s'étendant en travers du volume interne depuis une première paroi principale participant à définir le volume interne jusqu'à une deuxième paroi principale participant à définir le volume interne du dispositif de maintien.

L'étendue du renfort à travers le volume interne permet à la fois de rigidifier le corps creux puisque le renfort prolongeant la première paroi vient prendre appui sur la deuxième paroi opposée, mais participe aussi à définir la hauteur du dispositif de maintien, c'est-à-dire la dimension verticale entre la première paroi et la deuxième paroi. L'étendue du renfort a donc un effet sur le positionnement vertical, selon la direction dans laquelle est mesurée cette étendue du renfort d'une paroi à l'autre du dispositif de maintien, du composant électronique rendu solidaire de la plaque de refroidissement.

Cette dimension du renfort peut être ajustée de façon à positionner verticalement le composant électronique conformément à une position théorique souhaitée pour qu'il soit raccordé à une carte de circuit imprimé sur laquelle le dispositif électrique dans son ensemble doit être relié via les broches de connexion du composant électronique.

Selon une caractéristique optionnelle de l'invention, le renfort est un bord d'extrémité libre de la tôle du dispositif de maintien.

Le renfort est un bord d'extrémité libre participant à définir la première paroi du dispositif de maintien et plié pour traverser le corps creux et venir au contact de la deuxième paroi de sorte que ce renfort définisse une hauteur du corps creux entre la première paroi et la deuxième paroi du dispositif de maintien.

Selon une caractéristique optionnelle de l'invention, le dispositif de maintien est rendu solidaire de la plaque de refroidissement par un moyen d'attache thermique.

Selon une caractéristique optionnelle de l'invention, les moyens d'attache thermique sont des pâtes à braser permettant de bloquer le positionnement du composant électronique sur la plaque de refroidissement ou le dispositif de maintien contre la plaque de refroidissement après passage dans les moyens d'assemblage. Les moyens d'attache thermique peuvent être des joints de brasage, de frittage ou d'une résine thermodurcissable (époxy).

L'utilisation d'un moyen d'attache thermique similaire pour solidariser le module de puissance de la plaque de refroidissement ainsi que la plaque de refroidissement du dispositif de maintien permet de ne réaliser qu'un seul passage dans un four. Ceci permet de réduire le temps de fabrication tout en assurant un bon maintien de la plaque de refroidissement au cours de la descente en température.

Selon une caractéristique optionnelle de l'invention, le matériau utilisé pour le dispositif de maintien présente un coefficient de dilatation thermique plus faible que le coefficient de dilatation thermique de la plaque de refroidissement.

En présentant un coefficient de dilatation plus faible le dispositif de maintien subit une flexion plus faible lors du passage dans un four et fait ainsi office de système anti-flexion de la plaque de refroidissement. Le dispositif de maintien peut comprendre du nickel Le dispositif de maintien peut être réalisé en cuivre. Le dispositif de maintien peut être réalisé en acier, notamment avec un revêtement galvanique tel que du nickel ou en acier inoxydable. Le coefficient de dilatation thermique (CTE) du dispositif de maintien peut être inférieur à 15ppm/K, notamment 12ppm/K.

D'autres caractéristiques et avantages de l'invention apparaîtront encore au travers de la description qui suit d'une part, et de plusieurs exemples de réalisation donnés à titre indicatif et non limitatif en référence aux dessins schématiques annexés d'autre part, sur lesquels :
[fig 1] est une représentation schématique d'un dispositif électrique selon l'invention, comprenant un premier mode de réalisation d'un dispositif de maintien ;
[fig 2] est une représentation schématique d'un deuxième mode de réalisation du dispositif de maintien comprenant des bossages ;
[fig 3] est une représentation schématique d'un troisième mode de réalisation du dispositif de maintien comprenant des pliures ;
[fig 4] est une représentation schématique d'un quatrième mode de réalisation du dispositif de maintien comprenant des pliures et des renforts ;
[fig 5] est une représentation schématique d'un cinquième mode de réalisation du dispositif de maintien comprenant des pliures, des renforts et des parois latérales ;
[fig 6] est une représentation schématique d'une sixième mode de réalisation du dispositif de maintien comprenant des pliures et un renfort ;
[fig 7] est une représentation schématique d'une septième mode de réalisation du dispositif de maintien comprenant des bossages et des parois latérales ;
[fig 8] est une représentation schématique d'une huitième mode de réalisation du dispositif de maintien comprenant des pliures.

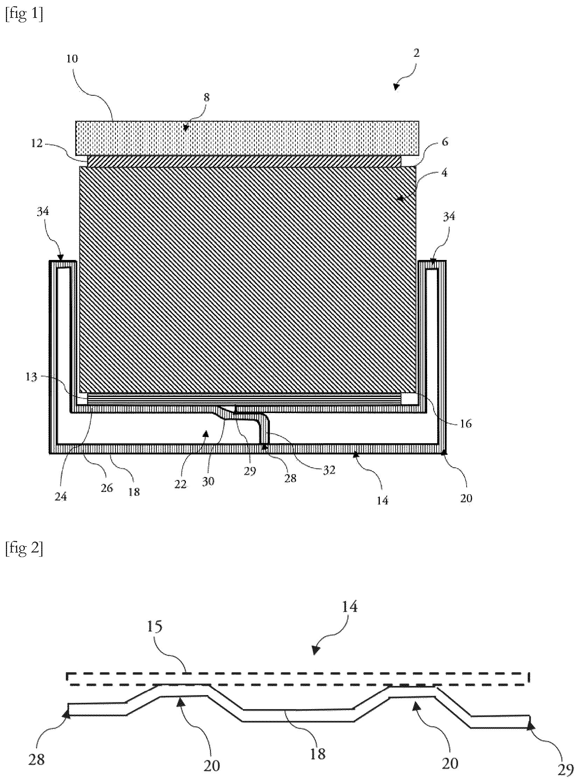

La figure 1 est une représentation schématique du dispositif électrique 2. Le dispositif électrique 2 comprend une plaque de refroidissement 4 apte à recevoir des composants électroniques 8 sur une face supérieure 6. Les composants électroniques peuvent par exemple consister en un module de puissance, formé d'un boîtier 10 au sein duquel sont logées des puces électroniques et qui sont destinées à être raccordées à un circuit électronique associé au dispositif électrique. Dans la suite de la description, il sera fait état d'un module de puissance 8 mais il convient de noter que tout autre type de composant électronique pourrait être mis en œuvre sans sortir du contexte de l'invention.

Le module de puissance 8 présente une forme plane sur la portion inférieure de son boitier 10, la forme plane étant configurée pour venir en recouvrement d'une partie de la face supérieure 6 de la plaque de refroidissement 4.

Un moyen d'attache thermique 12 tel qu'une pâte à braser est disposé entre la plaque de refroidissement 4 et le module de puissance 8. Le moyen d'attache thermique 12 est configuré pour se lier à la plaque de refroidissement 4 et au module de puissance 8 de sorte que ceux-ci soient rendus solidaires l'un de l'autre. Le moyen d'attache peut être alternativement un joint brasé, un joint fritté ou une résine thermodurcissable. Le moyen d'attache thermique 12 est notamment destiné à se dilater puis se figer lorsqu'il est soumis à de fortes températures puis refroidi, ce qui permet la fixation du module de puissance 8 sur la plaque de refroidissement 4. La fixation peut se faire par brasage, frittage ou collage. A cet effet, la plaque de refroidissement 4 et les composants électroniques qui sont destinés à reposer contre cette plaque sont amenés dans des moyens d'assemblage, par exemple une étuve, par exemple un four, par exemple une presse, pour faire fondre le moyen d'attache thermique 12, puis laissés au repos pour refroidir.

Lors de ces étapes, la plaque de refroidissement 4 et le module de puissance 8 sont amenés à se déformer notamment lors de la montée en température au sein du four. Les coefficients de dilatation thermique et le dimensionnement des pièces sont différents pour la plaque de refroidissement 4 et le module de puissance 8 ce qui peut impliquer des contraintes fortes sur le boitier 10 du module de puissance 8 étant donné que la plaque de refroidissement 4 contre lequel il est solidarisé se déforme plus que le boitier 10 du module de puissance 8. De plus, le module de puissance 8 redescend en température plus rapidement que la plaque de refroidissement 4 ce qui implique que la plaque de refroidissement 4 subit encore une flexion tandis que le module de puissance 8 est à température ambiante, ce qui peut déformer le module de puissance 8 lorsque la plaque de refroidissement 4 continu à descendre en température.

Selon l'invention, un dispositif de maintien 14 est associé à la plaque de refroidissement 4 pour réduire la flexion de ladite plaque de refroidissement 4 et ce dispositif de maintien 14 prend la forme d'une tôle à laquelle on donne une configuration permettant de conférer une rigidité à moindre coût. Le dispositif de maintien 14 est solidaire de la plaque de refroidissement 4, en étant disposé en regard d'une face inférieure 16 de cette plaque de refroidissement 4.

Tel que cela va être décrit en référence à plusieurs modes de réalisation illustrés, le dispositif de maintien 14 est formé d'une tôle 18 comprenant des zones de déformation locale 20. Les zones de déformation locale 20 sont par exemple des pliures ou des bossages réalisés dans la tôle 18. De telles zones de déformation locale 20 sont réalisées de façon à renforcer structurellement le dispositif de maintien 14, par exemple en formant un corps creux aussi résistant à la flexion qu'une pièce réalisée d'un seul tenant, étant entendu que la réalisation via une tôle permet de limiter le coût et le poids du dispositif électrique 2 ainsi obtenu.

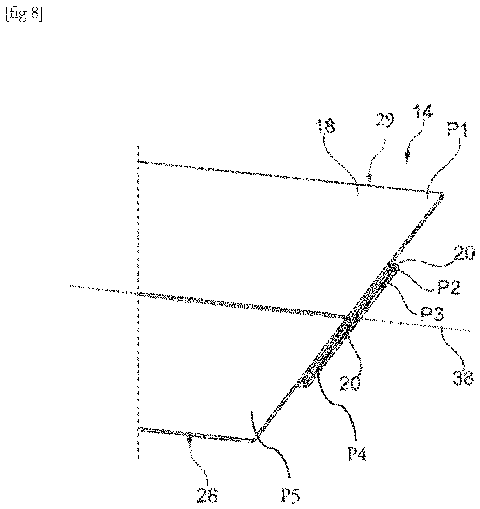

La plaque de refroidissement 4 et le dispositif de maintien s'étendent principalement le long d'un axe d'allongement 38 longitudinal, visible sur la figure 8, les figures 1 à 7 illustrant un plan de coupe perpendiculaire à cet axe d'allongement 38.

Le dispositif de maintien 14 présente un coefficient de dilatation thermique moins important que celui de la plaque de refroidissement 4. Le dispositif de maintien 14 a pour vocation de moins se déformer que la plaque de refroidissement 4 lors du passage du dispositif électrique 2 dans le four et donc de réduire la flexion de la plaque de refroidissement 4 et de limiter les contraintes sur chaque module de puissance 8 rendu solidaire de la plaque de refroidissement 4.

Le dispositif de maintien 14 est rendu solidaire de la plaque de refroidissement 4, ici via un moyen d'attache thermique 13 similaire au moyen d'attache thermique 12 interposé entre le module de puissance 8 sur la plaque de refroidissement 4. Le moyen d'attache thermique 13 peut donc être de la pâte à braser telle que celle décrite pour rendre solidaire le module de puissance 8 de la plaque de refroidissement 4. Bien entendu, on pourrait envisager sans sortir du contexte de l'invention que le matériau mis en œuvre pour réaliser le moyen d'attache thermique 13 associé au dispositif de maintien 14 soit différent de celui mis en œuvre pour réaliser le moyen d'attache thermique 12 associé au module de puissance 8. Le fait d'utiliser des moyens d'attache thermique 12 similaires pour la fixation sur la plaque de refroidissement 4 du module de puissance 8 et du dispositif de maintien 14 permet de ne réaliser qu'un seul passage dans le four pour solidariser tout l'ensemble du dispositif électrique 2.

Il convient de noter qu'en alternative, le dispositif de maintien peut être rendu solidaire de la plaque de refroidissement par d'autres moyens, et par exemple par soudage, collage, frittage et pressage en température si les matériaux du dispositif de maintien et de la plaque de refroidissement sont compatibles.

La figure 1 représente un premier mode de réalisation du dispositif de maintien 14, dans lequel les zones de déformation locale 20 sont formées par des pliures. Il convient de noter que la figure 1 est une vue en coupe du système électronique et notamment du dispositif de maintien. Selon le premier mode de réalisation, les zones de déformation locale 20 sont parallèles et continues selon l'axe d'allongement 38 de la plaque de refroidissement 4.

La tôle 18 est pliée de façon à former un volume interne 22 délimitées notamment par deux portions de la tôle 18 qui forment deux parois principales 24, 26 de ladite tôle 18 à distance l'une de l'autre et parallèles entre elles. De la sorte, lorsque le dispositif de maintien 14 est associé à la plaque de refroidissement, les deux parois principales 24, 26 de la tôle sont parallèles à la face inférieure 16 de la plaque de refroidissement 4.

La tôle 18 comprend deux bords d'extrémité libre 28, 29 se rejoignant pour fermer le volume interne 22 du dispositif de maintien 14. On comprend que lorsque la tôle 18 est plane, avant pliage pour former le dispositif de maintien ici représenté, les deux bords d'extrémité libre sont deux bords opposés. Un premier bord d'extrémité libre 28 est plié de manière à former un décrochage 30 permettant au second bord d'extrémité libre 29 de se positionner dans le décrochage 30.

Le décrochage 30 est une zone de déformation locale 20 correspondant à une pliure de la tôle 18 permettant de modifier la position du premier bord d'extrémité libre 28 de la tôle 18, et permettant notamment de modifier localement la hauteur, selon une direction perpendiculaire au plan d'une des parois principales, du corps creux. Le décrochage 30 s'étend dans le volume interne 22 du dispositif de maintien 14. Le décrochage 30 permet de former un dégagement d'une hauteur sensiblement égale à l'épaisseur de la tôle. De la sorte la face inférieure 16 de la plaque de refroidissement 4, par l'intermédiaire du moyen d'attache thermique 12, peut être disposée sur une portion plane du dispositif de maintien 14 formé par une première des deux parois principales 24.

Selon une variante non représentée sur les figures du premier mode de réalisation, le dispositif de maintien 14 ne comprend pas de décrochage 30, de sorte que les bords d'extrémités libre 28, 29 de la tôle 18 sont en regard l'un de l'autre.

Dans le premier mode de réalisation présenté figure 1, le dispositif de maintien 14 comprend par ailleurs un renfort 32 formé par le premier bord d'extrémité libre 28 de la tôle 18. Ce premier bord d'extrémité libre 28 est plié pour former le renfort 32 dans le prolongement du décrochage 30, étant entendu qu'un tel renfort 32 pourrait être mis en œuvre pour les avantages qui vont être détaillés ci-après sans qu'un décrochage préalable soit réalisé.

Le premier bord d'extrémité libre 28 est plié pour former le renfort 32 sous la forme d'une paroi qui s'étend perpendiculairement aux deux parois principales 24, 26, depuis la première paroi principale 24 comportant le deuxième bord d'extrémité libre 29 vers la deuxième paroi principale 26 opposée. Le renfort 32 correspond à une zone de déformation locale 20 comprenant une pliure à 90° de la tôle 18. Cette pliure est au contact de la deuxième paroi principale 26 qui forme une paroi de reprise d'efforts. Le renfort 32 permet ainsi de soutenir la paroi sur laquelle est disposée la plaque de refroidissement 4 et cela permet de renforcer structurellement le dispositif de maintien 14 de façon à limiter la flexion de celui-ci.

Tel que dit précédemment, le renfort 32 s'étend entre deux parois principales 24, 26 délimitant le volume interne 22 du dispositif de maintien 14, avec le renfort 32 qui prolonge une première paroi principale 24 en regard de la face inférieure 16 de la plaque de refroidissement 4 et qui s'étend jusqu'à être en contact avec une seconde paroi principale 26 parallèle à la première paroi principale 24 et formant ainsi une paroi de fond du dispositif de maintien 14. La disposition du renfort 32 entre la première paroi principale 24 et la seconde paroi principale 26 permet bien entendu de rigidifier l'ensemble, en formant une reprise d'effort de la première paroi principale 24 sur la deuxième paroi principale 26 opposée. Cela permet également de définir la hauteur du volume interne en fonction de la longueur du renfort.

Ainsi, faire varier la longueur du renfort 32 permet de modifier le positionnement vertical, selon la direction perpendiculaire aux plans des parois principales 24, 26 du dispositif de maintien 14, de la plaque de refroidissement 4 et du composant électronique 8, et ceci permet de s'assurer que le composant électronique 8 est à la bonne position pour pouvoir être raccordé au reste d'un circuit électronique, par exemple à une carte de circuits imprimés non représenté sur les figures.

Le dispositif de maintien 14 selon une variante non représentée du premier mode de réalisation peut ne pas comprendre de renfort 32. Dans cette variante les deux bords d'extrémités libre 28 sont superposées au niveau du décrochage 30 ou les deux bords d'extrémités libre 28 sont en regard l'un de l'autre.

Le dispositif de maintien 14 selon le premier mode de réalisation comprend deux parois latérales 34 qui s'étendent respectivement en saillie de la première paroi principale 24 par un jeu de pliures permettant de former un corps creux additionnel qui s'étend sur le côté de la plaque de refroidissement, dans le prolongement du corps creux principal disposé lui sous la plaque de refroidissement 4. Dans l'exemple illustré, la portion plane du dispositif de maintien 14 sur laquelle est disposée la plaque de refroidissement 4 comprend sur ses bords une pluralité de pliure formant les parois latérales 34. Tel que précédemment évoqué, les pliures permettant la formation des parois planes 34 sont formés le long d'une direction perpendiculaire au plan de coupe de la figure 1, parallèlement aux autres pliures du dispositif de maintien 14. Les parois latérales 34 sont disposées, selon une direction transversale, à une distance l'une de l'autre qui est sensiblement supérieure à la dimension correspondante de la face inférieure 16 de la plaque de refroidissement 4. Le positionnement de la plaque de refroidissement 4 est ainsi centré par les parois latérales 34 bloquant la translation selon cette direction transversale de la plaque de refroidissement 4.

Chaque paroi latérale 34 est sensiblement parallèle à un bord de la plaque de refroidissement 4. Les bords de la plaque de refroidissement 4 peuvent comprendre un épaulement non représenté sur la figure 1 venant reposer sur une portion supérieure d'une paroi latérale 34. Ainsi les parois latérales 34 présentent une hauteur apte à bloquer la plaque de refroidissement 4. La hauteur des parois latérales 34 est mesurée selon une direction perpendiculaire à la première paroi principale 24 du dispositif de maintien 14 et est définie entre la première paroi principale 24 et la portion supérieure de la paroi latérale 34. La figure 2 est une représentation schématique d'un deuxième mode de réalisation du dispositif de maintien 14 dans lequel les zones de déformation locale 20 sont formées par une pluralité de bossages réalisés par estampage de la tôle 18. L'estampage permet de renforcer localement la tôle 18 du dispositif de maintien 14, réduisant alors sa capacité de flexion lors du passage dans un four. L'estampage correspond à la déformation de la tôle 18 par une matrice présentant la forme des bossages. Le mode de réalisation par estampage selon la figure 2 est moins couteux à réaliser du fait qu'il n'est pas nécessaire de prévoir des moyens de pliage de la tôle. En une opération de frappe de la tôle, les différents bossages peuvent être effectués. Ce mode de réalisation permet de réduire la flexion de la plaque de refroidissement 4 à moindre coup.

Le dispositif de maintien 14 peut aussi comprendre une paroi de support 15 représentée en pointillé sur la figure 2 serti contre la tôle 18 du dispositif de maintien 14. La paroi de support 15 est sertie contre les bossages de la tôle 18. La paroi de support 15 permet de rigidifier le dispositif de maintien 14 ainsi que de présenter une paroi plane permettant un positionnement plus simple du moyen d'attache thermique 12.

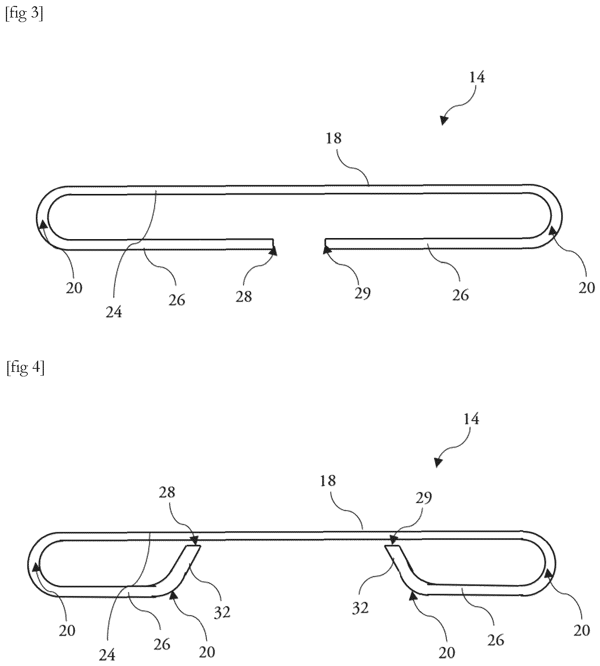

La figure 3 est une représentation schématique d'un troisième mode de réalisation du dispositif de maintien 14 dans lequel la tôle 18 comprend une pluralité de zones de déformation locale 20 telle que des pliures formant un dispositif de maintien 14 plus simple que le premier mode de réalisation du dispositif de maintien 14. Les pliures des zones de déformation locale 20 sont parallèles et continues le long de l'axe d'allongement 38 de la plaque de refroidissement 4.

Selon le troisième mode de réalisation, les zones de déformation locale 20 de la tôle comprennent deux pliures formant un angle à 180° pour replier sur elle-même la tôle 18, les deux pliures étant formées à chaque extrémité selon la direction transversale de manière à former deux parois principales 24, 26 parallèles l'une par rapport à l'autre. La première paroi principale 24 est la paroi supérieure destinée à être en regard de la plaque de refroidissement 4. La première paroi principale 24 est plane et continue de façon à recevoir le moyen d'attache thermique 14, et elle correspond à cet effet à une portion centrale de la tôle selon la direction transversale.

La seconde paroi principale 26 est formée des deux portions de la tôle 18 repliées sous la première paroi principale 24 et comprenant respectivement l'un des deux bords d'extrémité libre 28, 29 selon la direction transversale évoquée. Ces deux bords d'extrémité libre 28, 29 sont disposés en regard l'un de l'autre pour former la seconde paroi principale 26 sensiblement plane, ajourée en son centre.

La figure 4 est une représentation schématique d'un quatrième mode de réalisation du dispositif de maintien 14 s'inspirant du troisième mode de réalisation, mais qui diffère de celui-ci en ce que le dispositif de maintien incorpore des renforts 32.

Plus particulièrement, selon le quatrième mode de réalisation les bords d'extrémités libre 28 du dispositif de maintien 14 comprennent une zone de déformation locale 20 consistant en une pliure vers l'intérieur du dispositif de maintien, cette pliure formant un renfort 32 apte à être en contact avec la première paroi principale 24 du dispositif de maintien 14. Les renforts 32 permettent de renforcer structurellement le dispositif de maintien 14 et d'éviter encore plus efficacement une flexion de la plaque de refroidissement 4 par rigidification à moindre coût du dispositif de maintien 14.

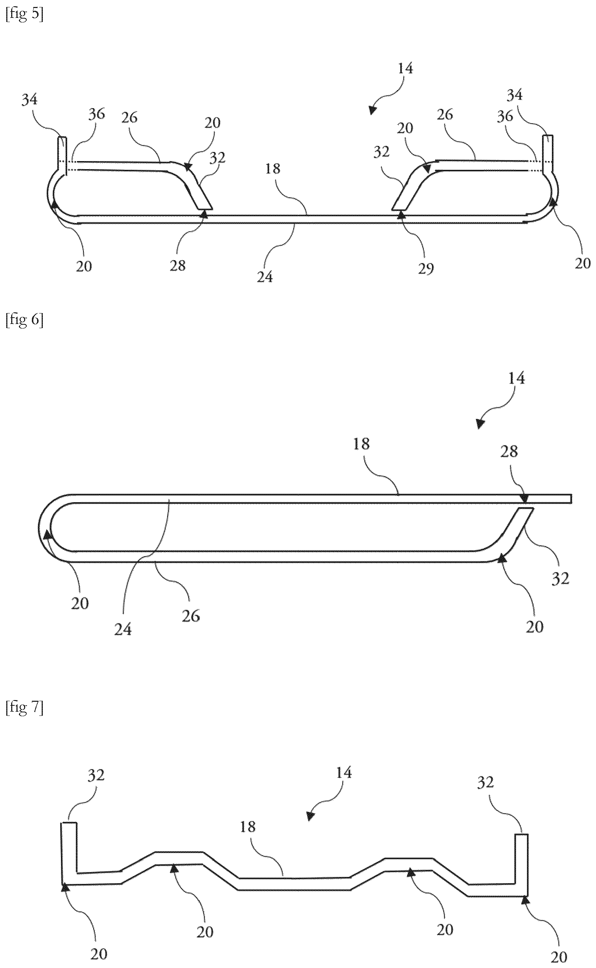

La figure 5 est une représentation schématique d'un cinquième mode de réalisation du dispositif de maintien 14 qui diffère du quatrième mode de réalisation d'une part en ce que c'est cette fois la deuxième paroi principale 26 qui est la portion du dispositif de maintien 14 en regard de la plaque de refroidissement 4 et du moyen d'attache thermique 12 interposé entre la plaque de refroidissement 4 et le dispositif de maintien 14 et d'autre part par la présence de parois latérales 34.

L'ajour présent au centre de la deuxième paroi principale n'est pas pénalisant dans la mesure où les portions repliées participant à former cette deuxième paroi principale 26 du dispositif de maintien 14 s'étendent sensiblement dans un même plan et ne peuvent s'affaisser du fait de la présence des renforts 32 formés par pliure tel que précédemment évoqué.

Les parois latérales 34 s'étendent comme pour le premier mode de réalisation aux extrémités transversales du dispositif de maintien 14 et permettent là aussi de centrer et de bloquer transversalement la plaque de refroidissement 4 avant que le dispositif électrique 2 ne soit passé dans un four. Les parois latérales 34 permettent d'assurer le bon positionnement relatif de la plaque de refroidissement 4 et du dispositif de maintien 14.

Dans ce cinquième mode de réalisation, les parois latérales 34 sont là aussi formées par une déformation locale 20. Toutefois, elles sont obtenues par une opération préalable de découpe 36 locale dans le dispositif de maintien 14, les parois latérales 34 résultant d'une déformation locale 20, et notamment un pliage, de la zone découpée. Il résulte de ce procédé que les parois latérales 34 ne s'étendent pas sur toute la dimension du dispositif de maintien 14 contrairement aux autres modes de réalisation des parois latérales 34. En d'autres termes, les parois latérales 34 sont là encore en saillie de la première paroi principale 24 du dispositif de maintien 14, et les zones de déformation locale 20 formant ces parois latérales 34 sont parallèles à l'axe d'allongement 38, mais elles sont ici non continues le long de l'axe d'allongement 38 de la plaque de refroidissement 4, puisqu'elles ne s'étendent par sur toute la dimension du dispositif de maintien 14.

La figure 6 est une représentation schématique d'un sixième mode de réalisation du dispositif de maintien 14, qui se distingue de ce qui précède en ce que la tôle 18 formant le dispositif de maintien 14 comprend une unique zone de déformation locale 20 assimilable à une pliure pour former les deux parois principales 24, 26 parallèles entre elles. Les zones de déformation locale 20 sont parallèles et continues le long de l'axe d'allongement 38 de la plaque de refroidissement 4.

Le bord d'extrémité libre 28 de la deuxième paroi 26 comprend comme précédemment un renfort 32 s'étendant de la deuxième paroi 26 jusqu' à la première paroi principale 24. Le renfort 32 permet dans ce sixième mode de réalisation de maintenir parallèle la première paroi principale 24 de la deuxième paroi principale 26, et le cas échéant de jouer sur la hauteur du dispositif de maintien 14 tel qu'évoqué dans le premier mode de réalisation. La première paroi principale 24 est une paroi plane apte à recevoir les moyens d'attache thermique 12 ainsi que la face inférieure 16 de la plaque de refroidissement 4. Le volume interne 22 est défini entre la pliure et le renfort 32 du dispositif de maintien 14.

La figure 7 est une représentation schématique d'un septième mode de réalisation du dispositif de maintien 14 se basant sur le deuxième mode de réalisation précédemment décrit en référence à la figure 2 et se distinguant ici en ce qu'il comprend des parois latérales 34 formées par des pliures, ici sensiblement à angle droit, à chaque bord d'extrémité libre 28, 29 de la tôle. Les pliures formant les parois latérales 34 sont parallèle et continu selon l'axe d'allongement 38 de la plaque de refroidissement 4.

La figure 8 est une représentation schématique d'un huitième mode de réalisation du dispositif de maintien 14 comprenant une pluralité de zones de déformation locale 20. Les zones de déformation locale 20 de ce mode de réalisation sont des pliures. Quatre pliures parallèles dans la tôle 18 forment le dispositif de maintien 14.

Dans ce mode de réalisation, les bords d'extrémités libre 28, 29 de la tôle 18 sont tournés à l'opposé l'un de l'autre, en s'éloignant respectivement de l'axe d'allongement 38 de la tôle 18 du dispositif de maintien 14. Les zones de déformation locale 20 sont parallèles entre elles, et continues, le long de l'axe d'allongement 38 de la plaque de refroidissement 4.

La tôle 18 du dispositif de maintien 14 comprend cinq parties P1, P2, P3, P4, P5 entre chacune des zones de déformation locale 20. Chaque pliure est formée par un angle à 180°. La tôle 18 comprend une succession de pliures opposées par rapport à l'axe d'allongement 38 de la tôle 18, de sorte que la tôle 18 du dispositif de maintien 14 présente une forme symétrique par rapport à un plan contenant l'axe d'allongement 38 de la tôle 18.

Étant donné cette symétrie de la tôle 18, la moitié du dispositif de maintien 14 sera décrite. Une pliure à 180° est disposée à l'extrémité de la partie centrale P3, la pliure étant disposée de sorte que celle-ci génère une portion de tôle qui vient s'étendre sur le coté supérieur de la partie centrale P3. À la suite de cette pliure, une partie d'extension P2 s'étend entre la pliure de la partie centrale P3 et une seconde pliure à 180°. La seconde pliure à 180° est disposée de sorte que celle-ci génère une portion de tôle qui vient s'étendre sur le coté supérieur de la partie d'extension P2. De la seconde pliure s'étend la partie supérieure P1 qui lorsque la symétrie de la tôle 18 est réalisée forme la paroi plane contre laquelle est disposée le moyen d'attache thermique 12 ainsi que la plaque de refroidissement 4. Chaque partie symétrique du dispositif de maintien 14 forme un serpentin permettant d'améliorer la résistance structurelle du dispositif de maintien 14.

L'invention, telle qu'elle vient d'être décrite, atteint bien le but qu'elle s'était fixé, et permet de proposer un dispositif électrique. Des variantes non décrites ici pourraient être mises en œuvre sans sortir du contexte de l'invention, dès lors que, conformément à l'invention, elles comprennent un dispositif de maintien de la plaque de refroidissement apte à réduire la flexion de ladite plaque de refroidissement conformément à l'invention.

## Revendications

1. Dispositif électrique (2) comprenant une plaque de refroidissement (4), des composants électroniques disposés sur ladite plaque de refroidissement (4), la plaque de refroidissement (4) présentant une face supérieure (6) en regard d'au moins un composant électronique (8) et une face inférieure (16) opposée, un moyen d'attache thermique (12) étant disposé entre l'au moins un composant électronique (8) et la face supérieure (6) de la plaque de refroidissement (4), un dispositif de maintien (14) étant rendu solidaire de la face inférieure (16) de la plaque de refroidissement (4), **caractérisé en ce que** le dispositif de maintien (14) est formé d'une tôle (18) comprenant des zones de déformation locale (20) aptes à renforcer structurellement le dispositif de maintien (14).

2. Dispositif électrique (4) selon la revendication précédente, dans lequel la tôle du dispositif de maintien comprend une pluralité de pliures donnant au dispositif de maintien la forme d'un corps creux.

3. Dispositif électrique (2) selon l'une des revendications précédentes, dans lequel la tôle (18) du dispositif de maintien (14) est pliée de sorte que le dispositif de maintien (14) présente deux parois principales (24, 26) sensiblement parallèle à la face inférieure (16) de la plaque de refroidissement et à distance l'une de l'autre pour définir un volume interne (22).

4. Dispositif électrique (2) selon l'une des revendications précédentes, dans lequel la tôle du dispositif de maintien est pliée de sorte qu'un bord d'extrémité libre (28) du dispositif de maintien (14) rejoint un autre bord d'extrémité libre (29) pour fermer le volume interne (22).

5. Dispositif électrique (2) selon la revendication précédente, dans lequel un bord d'extrémité libre (28) comprend une pliure formant un décrochage (30) dimensionné pour recevoir l'autre bord d'extrémité libre (29).

6. Dispositif électrique (2) selon l'une des revendications précédentes, dans lequel au moins une zone de déformation locale (20) est formée par un bossage résultant d'une opération d'estampage.

7. Dispositif électrique (2) selon l'une quelconque des revendications précédentes, dans lequel le dispositif de maintien (14) présente une paroi de support sensiblement parallèle à la face inférieure de la plaque de refroidissement (4) et destinée à permettre la fixation du dispositif de maintien (14) sur la plaque de refroidissement, le dispositif de maintien présentant en outre au moins une paroi latérale (34) prolongeant sensiblement perpendiculairement la paroi de support et venant au contact d'au moins un bord de la plaque de refroidissement (4).

8. Dispositif électrique (2) selon la revendication précédente, dans lequel le dispositif de maintien (14) comprend deux parois latérales (34) en regard de deux bords opposés de la plaque de refroidissement (4).

9. Dispositif électrique (2) selon l'une des revendications 7 ou 8, dans lequel la paroi latérale (34) est formée par des pliures dans la tôle (18) du dispositif de maintien (14).

10. Dispositif électrique (2) selon l'une des revendications 7 à 9 en combinaison avec la revendication 3, dans lequel le dispositif de maintien (14) comporte un renfort (32) s'étendant en travers du volume interne (22) depuis une première paroi principale (24) participant à définir le volume interne (22) jusqu'à une deuxième paroi principale (26) participant à définir le volume interne (22) du dispositif de maintien (14).

11. Dispositif électrique (2) selon la revendication précédente, dans lequel le renfort (32) est un bord d'extrémité libre (28) de la tôle (18) du dispositif de maintien (14).

12. Dispositif électrique (4) selon l'une des revendications précédentes, dans lequel le dispositif de maintien (14) est rendu solidaire de la plaque de refroidissement (4) par un moyen d'attache thermique (13).

13. Dispositif électrique (2) selon la revendication précédente, dans lequel les moyens d'attache thermique (12, 13) sont des pâtes à braser permettant de bloquer le positionnement du composant électronique (8) sur la plaque de refroidissement (4) ou le dispositif de maintien (14) contre la plaque de refroidissement (4) après passage dans un four

14. Dispositif électrique (2) selon l'une quelconque des revendications précédentes, dans lequel le matériau utilisé pour le dispositif de maintien (14) présente un coefficient de dilatation thermique plus faible que le coefficient de dilatation thermique de la plaque de refroidissement (4).
